# EUROPÄISCHE PATENTSCHRIFT

(11) **EP 0 879 304 B1**
(45) Veröffentlichungstag und Bekanntmachung des Hinweises auf die Patenterteilung: **31.05.2000**
(21) Anmeldenummer: 97916314.4
(22) Anmeldetag: 06.02.1997
(51) Int. Cl.: C25D 1/00, C25D 1/10

(54) **HERSTELLUNG VON SCHRÄGEN GALVANIKSTRUKTUREN**
PRODUCTION OF BEVELLED GALVANIC STRUCTURES
PRODUCTION DE STRUCTURES GALVANIQUES INCLINEES

(30) Priorität: 06.02.1996 DE 19604242
(43) Veröffentlichungstag der Anmeldung: 25.11.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: MACIOSSEK, Andreas, D-10717 Berlin (DE)
(74) Vertreter: Leonhard, Frank Reimund, Dipl.-Ing.
(86) Internationale Anmeldenummer: DE9700226
(87) Internationale Veröffentlichungsnummer: WO9729222

(56) Entgegenhaltungen:
- Keine einschlägigen Dokumente gefunden

## Beschreibung

Das technische Gebiet der Erfindung ist die Herstellung von dreidimensional gestaltbaren Galvanikstrukturen auf Substraten, die im Stand der Technik noch von der Strukturierung durch Photolack und anschließender galvanischer Abscheidung ihre Möglichkeiten und Schranken erhalten.

Der Stand der Technik erläutert die Bildung von Galvanikstrukturen, die elektrisch leitfähig sind und in der Mikromechanik ein breites Anwendungsfeld finden, durch Aufbringen eines lichtempfindlichen Lacks, durch Belichten und Entfernen bestimmter Teile des aufgebrachten Lacks und anschließender galvanischer Abscheidung aus einem Galvanikfluid, das an ein erstes Potential angeschlossen ist, während die elektrisch leitende Basis auf dem Substrat als Plating-Base elektrisch mit dem entgegengesetzten Potential beaufschlagt wird. Die so hergestellten Galvanikstrukturen haben regelmäßig senkrecht verlaufende Randbereiche, da das Licht auf den Photolack immer senkrecht auftrifft, so daß nur senkrechte Lackstrukturen entstehen können. Demgemäß können auch nur solche Galvanikstrukturen entstehen, deren Randflächen in der Richtung verlaufen, in der auch das Licht eingefallen ist.

Die Erfindung hat es sich **zur Aufgabe gestellt,** die vom einfallenden Licht vorgegebenen Lackstrukturen als Vorlage für Galvanikstrukturen aufzugeben und es zu ermöglichen, frei gestaltbare Galvanikstrukturen zu schaffen, deren Randflächen nicht mehr zwingend vertikal oder nahezu vertikal verlaufen müssen. Die Erfindung schlägt dazu Lösungen gemäß Anspruch 1, Anspruch 16 und Anspruch 23 vor.

Gemäß diesem Lösungsweg werden die in Höhenrichtung gestaltbaren galvanisch abgeschiedenen Strukturen als Profile auf dem Substrat gebildet, wenn die zuvor aufgebrachte leitfähige Schicht in Ebenen-Richtungen (Lateralrichtung) strukturiert wird (Anspruch 1). Die dreidimensional beim Galvanisieren formbare Metallstruktur wird auch gebildet, wenn das Substrat zumindest eine leitfähige Schicht trägt, eine der mehreren oder die eine leitfähige Schicht in Lateralrichtung strukturiert wird durch Bildung mehrerer Inselbereiche, die gegeneiander keine oder keine wesentliche elektrische Leitung besitzen, und beim Galvanisieren einer der Inselbereiche als Kernbereich kathodisch geschaltet wird (Anspruch 16). Das Herstellungsergebnis - umschrieben anhand der Verfahrensschritte - ist im Anspruch 23 erfaßt, es ergibt sich entweder aufgrund des Verfahrens gemäß Anspruch 16 oder aufgrund des Verfahrens gemäß Anspruch 1.

Ausgehend von dem Verfahrenserzeugnis, das die dreidimensional geformte massive Metallstruktur mit überdeutlicher Erstreckung in Höhenrichtung ("Profil") ist, kann erkannt werden, daß nicht mehr alle vertikalen Randflächen dieser Struktur zwingend in vertikaler oder nahezu vertikaler Richtung verlaufen müssen. Das umschreibt allerdings nicht, daß alle Ränder zwingend jetzt in schräger oder gekrümmter Bahn verlaufen, sondern nur daß zumindest eine der vertikalen Flanken eine schräge oder eine gekrümmte Ebene ist, die mit bisherigen Herstellverfahren nicht gestaltbar war. Eine Fläche in Form einer lateral abgeschiedenen Schicht ist das erfindungsgemäße "Profil" nicht.

Photolack wird zwar nach wie vor eingesetzt, er bildet aber nicht mehr den Kern und die Basis für eine galvanische Abformung aufgrund von freibelichteten und geätzten Leitstrukturen, basierend auf einer Photolackschicht. Dieser Lack dient gemäß der Erfindung noch zur Gestaltung einer dreidimensionalen Struktur in Höhenrichtung, wenn er den Großteil des Kernbereiches abdeckt und nur einen kleinen Abschnitt freiläßt, über den kathodisches Potential in das Galvanikbad übertreten kann. Ausgehend von dem Potential in dem Galvanikfluid bildet sich eine langsam wachsende Schicht auf dem kleinen Teilbereich mit kathodischem Potential. Diese Schicht wächst in Vertikalrichtung auf und verbreitert sich dabei zwangsläufig auch geringfügig in Lateralrichtung.

Nachdem die Erfindung in Lateralrichtung beabstandete weitere Inselbereiche als zweite Bereiche zur Verfügung stellt, die aus der zunächst als gesamte Leitschicht aufgebrachten Plating-Base nach deren Strukturierung entstanden sind, entsteht eine Übergalvanisierung über die isolierten Bereiche von dem kathodischen Bereich zu dem davon beabstandeten nächsten strukturierten Bereich, der wiederum elektrisch leitfähig ist, der aber nicht an das kathodische Potential angeschlossen ist. Das so gesteuerte Übergalvanisieren in Lateralrichtung erlaubt es, abhängig von Abstand und Breite der nicht elektrisch angeschlossenen Inselbereiche die Schräge zu definieren, die durch längere oder kürzere Galvanisierung entsteht.

Die jeweilige Front der in Lateralrichtung wachsenden Schräge - als aufwachsendes Profil - erfährt immer dann ein sprunghaftes Wachstum, wenn sie als elektrisch leitfähige Schicht die nächste elektrisch leitende Insel erreicht, die dann folgende Ausbreitung in Lateralrichtung ist viel schneller, als diejenige, wenn gerade das Ende dieses Inselbereiches in Lateralrichtung erreicht wurde. Gesteuert durch die stufenweise laterale Ausbreitung und die sich dabei auch bildende substantielle Erhöhung der Leitstruktur kann ein beliebig geformtes Massivgebilde auf dem Substrat hergestellt werden, daß mit Verfahren der Lackbeschichtung, des Freilegens und der üblichen Galvanisierung bisher nicht herstellbar gewesen ist.

Kurz umschrieben läßt sich mit dem neuen Verfahren die laterale Aufwachsrate steuern, einmal durch Länge und Dauer der Galvanik, zum anderen - vor Beginn der Galvanik - durch Aufbringen bestimmter geometrischer Gestaltungen als Struktur in der Plating-Base, das dem Galvanikbad beim Galvanisieren ausgesetzt ist.

Das Verhältnis von lateraler zu vertikaler Aufwachsrate ergibt das Galvanikprofil.

Die Galvanikstrukturen können aus Gold oder Nickel bestehen. Die elektrisch leitende Startschicht (Plating-Base) kann aus denselben Materialien gebildet werden. Werden mehrere Plating-Bases verwendet, so werden sie von Zwischenlagen isoliert, vorzugsweise SiN-Schichten. Wird nur eine Plating-Base eingesetzt, so kann das Substrat selbst isolierend sein und eine zusätzliche Isolierschicht muß auf das Substrat nicht aufgebracht werden.

Arbeitet das erfindungsgemäße Herstellverfahren ohne dicke Lackschichten, so bildet sich kein seitlicher Rahmen für diejenigen vertikalen Flächen, die nicht schräg geformt werden sollen. Es ist dann möglich, die schräge Galvanikstruktur in allen Richtungen, z.B. kreis- oder elipsenförmig, aufwachsen zu lassen. Bei Verwendung von konzentrischen Inselgebieten zur Steuerung der lateralen Aufwachsgeschwindigkeit können auch konkave oder konvexe Formen mit fast unbegrenzter Höhe h entstehen.

Wird eine dicke Lackstruktur verwendet (Anspruch 6, Anspruch 19, Anspruch 20), so kann eine freie und durch stufiges Übergalvanisieren definierte Aufwachsrate in Lateralrichtung nur an den Bereichen entstehen, an denen der strukturierte Photolack keine Grenze definiert. An den Stellen, wo dicker Lack vorhanden ist, wird die Aufwachsrate begrenzt, die galvanische Abformung erfolgt nur in diejenige Richtung, in der keine Lackbegrenzung vorgegeben ist.

Vorteilhaft kann die Aufbringung von dicken Lackstrukturen auch kombiniert werden mit der völlig freien Plating-Base-Strukturierung, so daß in bestimmten Bereichen die Aufwachsrate in lateraler Richtung (x- und y-Richtung) begrenzt und eingegrenzt ist, in anderer Richtung dagegen aufgrund des strukturierten Plating-Bases vordefiniert ist.

Das erfindungsgemäße Verfahren ist sehr kostengünstig, es ist besonders gegenüber **einem bekannten Grauton-Lithographie-Prozeß** kostengünstiger, da diese Technologie darauf beruht, die Strukturen im Maskendesign kleiner zu machen als die Auflösung der Lithographie. Dadurch entstehen bei der Grauton-Lithographie keine Hell/Dunkel-Bereiche mehr, sondern eine Vermischung von Grautönen, was aber nur bei sehr aufwendigem Maskendesign erzielt wird und eine Stepperbelichtung mit einer Verkleinerungsoptik erfordert (vgl. "Microfabrication of complex surface topographies" in Sensors and Actuators, A 46-47, Seiten 89-94, 1995). Anders als die Grauton-Lithographie, die erst ein dreidimensionales Lackprofil erzeugt, das dann mit einer dünnen Metallschicht überzogen wird, um galvanisch abgeschieden werden zu können, erlaubt die Erfindung die Ausbildung massiver galvanischer Strukturen ohne darunter liegender Lackschichten und ohne Anwendung von Stepperbelichtung nur durch Verwendung einfacher und weit verbreiteter UV-Kontaktbelichter. Diese Geräte sind wesentlich preiswerter und die Ergebnisse, die mit ihnen erzielt werden, sind dementsprechend kostengünstiger.

Werden für die Erfindung Röntgenlithographien (LIGA-Technik) zur Strukturierung des dicken Lacks verwendet, so können dreidimensionale Strukturen von mehreren 100 µm Höhe erzielt werden. Bei der Verwendung von UV-Photolack und Kontaktbelichtern ist die Höhe der dicken (strukturierten) Lackschicht auf ca 100 µm begrenzt, aufgrund der maximalen Belichtungstiefe dieses Verfahrens. Die so gebildete Schranke gilt aber nur für die Herstellungs-Verfahren, die sich an dicken Photolacken orientieren, diejenigen Herstellungs-Verfahren der Erfindung, die ohne die Lackgrenzen als Randbereiche der Galvanik auskommen, sind von dieser Belichtungstiefe in ihrer Höhe nicht beschränkt, die Höhe bildet sich allein aufgrund der Zeitdauer, während der die Galvanikabformung durchgeführt wird.

Die Erfindung(en) werden nachfolgend anhand mehrerer Ausführungs**beispiele** erläutert und ergänzt.
- **Figur 1**: veranschaulicht das Substrat 10.
- **Figur 2**: zeigt den Verfahrensschritt, in dem eine leitende Startschicht (Plating-Base) 11 auf das Substrat 10 aufgebracht worden ist.
- **Figur 3**: verdeutlicht die laterale Strukturierung der Plating-Base unter Bildung eines Kernbereiches 11k und eines aus einer Vielzahl von Inseln bestehenden Insel-Bereiches 12ᵢ, wobei alle Inseln voneinandern isoliert angeordnet sind. Der entsprechende Isolierring 13a liegt innerhalb des vom Kernbereich 11a belassenen Fensters, in dem ohne elektrischen Kontakt zum Kernbereich 11ₖ die einzelnen isolierten Inselbereiche 12ᵢ als linienförmige und voneinander beabstandete Streifen 12₈,12₉,12₁₀... angeordnet sind.
- **Figur 4**: veranschaulicht als eine Verfahrensvariante das Aufbringen einer dicken Lackschicht 14 auf den Kernbereich 11ₖ unter Freilassung des Inselbereiches 12ᵢ mit der strukturierten Plating-Base. Die quaderförmige Lackschicht 14 mit Fenster kann in mehreren Stufen hergestellt sein, durch Belacken und Lithographie.
- **Figur 5**: zeigt das Ergebnis der Galvanikabformung durch einen Schrägbereich 20a, der sich innerhalb des Fensters der Figur 4 bildet, wenn der Kernbereich 11_{k'} kathodisch geschaltet wird und die Inselbereiche 12ᵢ elektrisch nicht angeschlossen werden (n.c.).
- **Figur 6**: zeigt das Verfahrensergebnis nach Entfernen der Lackschicht 14, wobei die als Kernbereich zuvor erläuterte Plating-Base 11ₖ noch verbleibt und der Schrägbereich 20a deutlich von dem Substrat 10 mit der Höhe hₘₐₓ hervorsteht.
- **Figur 7**: zeigt das Verfahrensergebnis nach Entfernen des Kernbreiches 11ₖ der Plating-Base, wobei auch der strukturierte Teil 12ᵢ der Plating-Base entfernt werden kann.

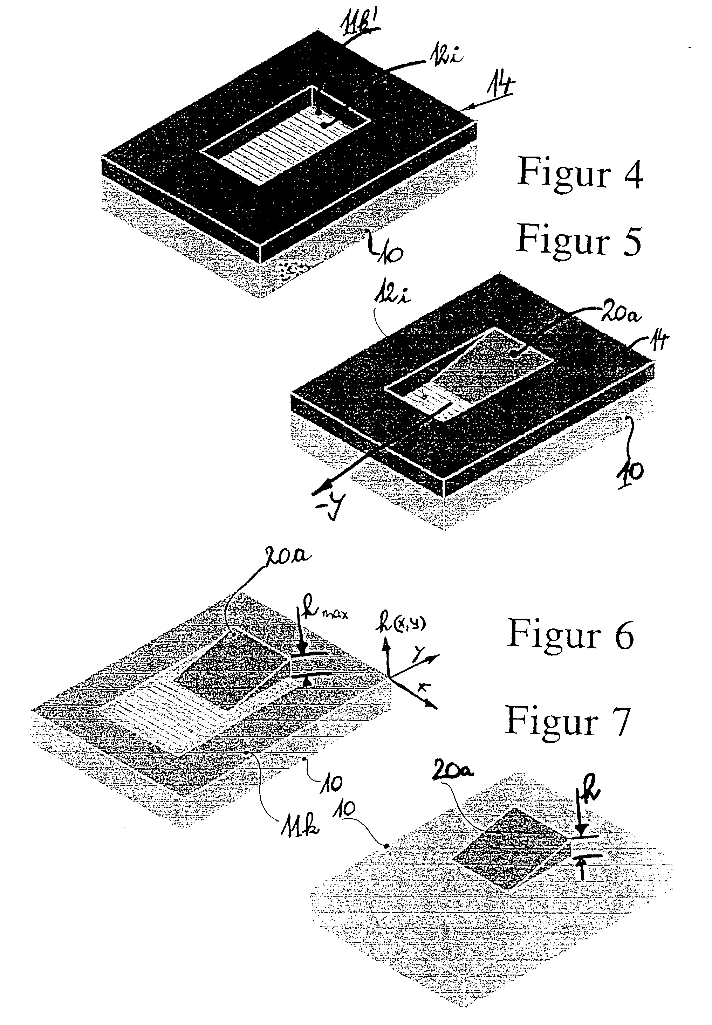

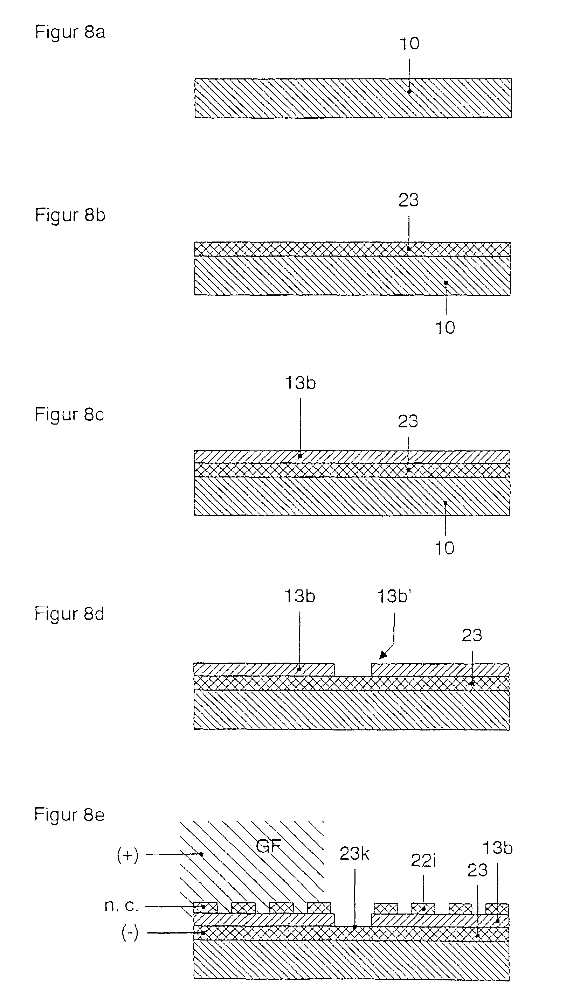

- **Figur 8a bis Figur 8e**: zeigt ein alternatives Galvanikverfahren zur Herstellung eines Schräggebildes, wie das der Figur 7, indem zwei übereinander aufgebrachte leitfähige Schichten voneinander durch eine Isolierschicht 13b getrennt sind und ein Fenster 13b' einen Teil 23ₖ der ersten Leitschicht 23 freilegt, um gemeinsam mit dem Inselbreich 22ᵢ, der aus der zweiten Leitschicht gebildet wurde, eine in Lateralrichtung gesteuerte Aufwachsrate zu erhalten. Schematisch ist in der Figur 8e die elektrische Verbindung (+) und (-) sowie n.c. angedeutet, wobei das positive Potential (+) am Galvanikfluid GF angelegt wird, das negative Potential (-) an der tiefer liegenden Plating-Base 23 und die Inselbereiche 22ᵢ elektrisch nicht angeschlossen werden (**n**ot **c**onnected).
- **Figur 9**: veranschaulicht in einem seitlichen Schnitt das lateral gesteuerte Aufwachsen der Galvaniksubstanz G, orientiert an einem Kernbereich 11ₖ und davon beabstandeter Inselbereiche 12₁,12₂...12ᵢ, die elektrisch über das Substrat 10 oder eine zusätzliche Isolierlage 13a von dem Kernbereich 11ₖ isoliert sind.
- **Figur 10 und Figur 10a**: verdeutlichen eine Einstellung für die entstehende Schrägstruktur, wobei der Schrägwinkel auf der Ordinate gegenüber dem Verhältnis von Insellänge I zu Zwischenabstand s aufgetragen ist. Je geringer die Breite jeder Insel (line) in x-Richtung ist und je größer der Abstand zweier Inseln (space) ist, desto steiler wird der Keilwinkel der beim Galvanisieren abgeformten Struktur.
- **Figur 11a und Figur 11b**: zeigen eine Nickelgalvanik und eine Goldgalvanik mit Schrägstruktur 20',20a auf einem strukturierten Substrat, das aus voneinander isolierten Streifen besteht, die den zuvor erwähnten Inselbereich bilden. Ein Streifen 11ₖ ist gegenüber den anderen Streifen verlängert und dient als Kernbereich, für kathodisches Potential.
- **Figur 12**: zeigt als ein Einsatzgebiet der Schräggalvanik einen Kippspiegel 40, der mit Keilstrukturen in seiner Schwenklage α verändert wird, wobei geringere Spannungen benötigt werden, um einen höheren Stellwinkel zu erzielen, gegenüber der in Figur 13 dargestellten Kippspiegel-Variante 30 mit ebenen Galvanikstrukturen.
- **Figur 13**: zeigt einen Kippspiegel 30 mit ebenen Galvanikstrukturen 91,90, der - bei gleicher Steuerspannung - nur einen geringen Stellwinkel β aufweist.
- **Figur 14**: verdeutlicht eine in zwei Ebenen-Richtungen x,y aufwachsenden Keilstruktur 20a, deren Randbereiche 20b nicht senkrecht zum Substrat 10 verlaufen, sondern eine deutlich gekrümmte Randfläche bilden, nach Art einer 1-e-Funktion.

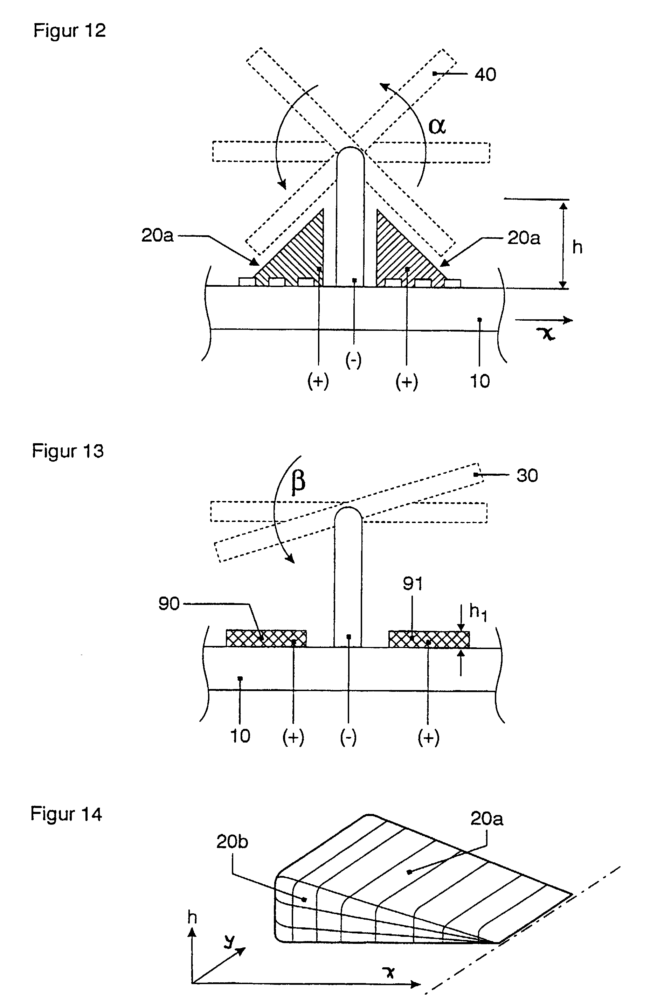

Orientiert am Verwendungszweck findet eine Schrägstruktur auf einem Substrat 10 Anwendung in der Mikromechanik (vgl. **Figur 12**). Dort wird eine gewünschte Schwenkbewegung α eines Kippspiegels 40, der auf einem Zapfen ruht, deutlich vergrößert bei geringeren elektrostatischen Potentialen (+) und (-), wenn Strukturen verwendet werden, die der Kippbewegung nahekommen, wie das keilförmige Schrägstrukturen 20a mit der Höhe h links und rechts vom Kippspiegel-Statorzapfen sind. Demgegenüber zeigt die **Figur 13,** daß eine Schwenkbewegung β eines dortigen Kippspiegels 30 nur gering ist, bei Verwendung gleicher Potentiale, wenn ebene Galvanikstrukturen 90,91 mit einer sehr viel geringeren Höhe h₁ eingesetzt werden. Werden die dortigen Galvanikstrukturen 90,91 dicker gestaltet, wird die Schwenkbewegung des Spiegels eingeschränkt, obwohl geringere Potentiale verwendet werden können. Bleibt die Galvanikstruktur 90,91 dünn, so muß für einen benötigten Schwenkwinkel eine sehr viel höhere Spannung angelegt werden, um vergleichbare Kräfte zu erzeugen.

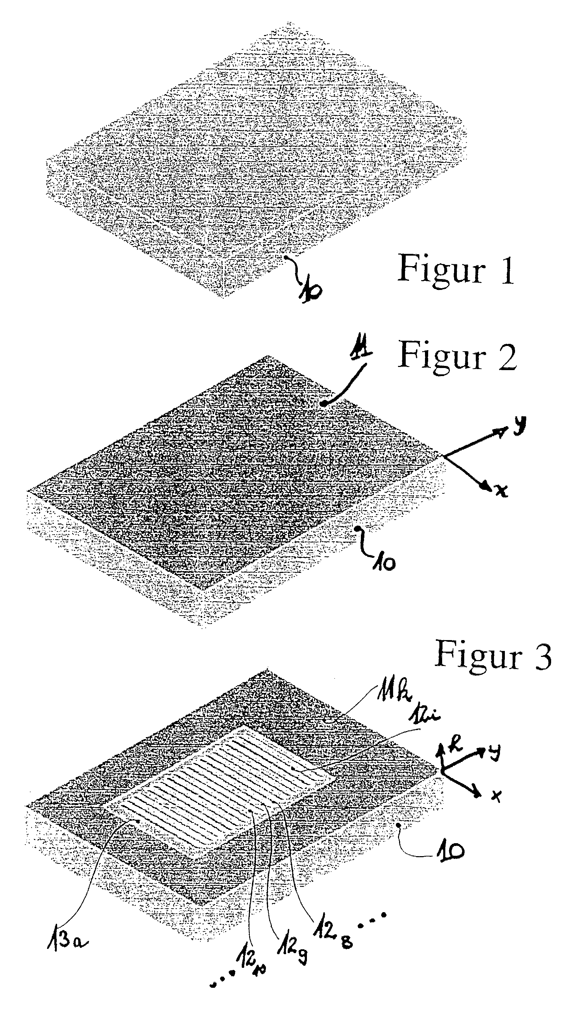

Die anhand des Verwendungszweckes erläuterte Schrägstruktur wird mit einem Verfahren erhalten, das gemäß den **Figuren 1 bis 7** oder gemäß den **Figuren 8a bis 8e** anschaulich anhand des jeweiligen Verfahrens-Zwischenproduktes nach jedem Verfahrensschritt erläutert wird. Zunächst wird auf ein im Beispiel nicht leitendes Substrat 10 eine elektrisch leitende Startschicht 11 aufgebracht (Figur 2). An dieser entladen sich die Metallionen der Galvaniklösung GF, die zur galvanischen Strukturerzeugung verwendet wrid. Anders als im Stand der Technik befindet sich auf der Plating-Base nicht zwingend ein strukturierter Photolack, sondern die Plating-Base 11 selbst wird in der x- y-Ebene zu leitenden Inselbereichen 12ᵢ strukturiert, die in diesem Beispiel als Linien 12₈,12₉,12₁₀ in einem von dem Kernbereich 11a der Plating-Base 11 freigelassenen Fenster gebildet werden. Umlaufend um die Linien-Struktur des strukturierten Inselbereichs 12ᵢ verläuft ein Isolierstreifen 13a, der den Kernbereich 11ₖ von dem Inselbereich 12ᵢ isolierend trennt. Im Ausführungsbeispiel ist der Streifen 13a die Oberfläche des isolierenden Substrates 10. Sofern das Substrat 10 selbst nicht isolierend ist, würde 13a ein Ausschnitt einer Zwischen-Isolierschicht zwischen der Plating-Base 11 aus Figur 2 und einem leitfähigen Substrat 10 sein.

Isolierend ist so zu verstehen, daß es keine wesentliche Stromleitung sein darf, ein geringerer Leckstrom, der nicht wesentlich zur Bildung eines stark negativen Potentials auf den Inseln 12ᵢ führt, ist unschädlich.

Eine dicke Photolackschicht 14 wird auf den Kernbereich 11ₖ der Figur 3 aufgebracht, diese dicke Lackschicht 14 wird teilweise (im Fenster) wieder frei belichtet und ergibt das Produkt gemäß Figur 4. An einem kleinen Teilstreifen 11k' ist noch der leitfähige Kern 11k der Plating-Base 11 zu erkennen, der übrige Kernbereich ist von der Lackschicht 14 abgedeckt. Frei bleibt also der strukturierte Plating-Base-Bereich 12ᵢ mit der Vielzahl von streifenförmigen Inseln.

Wird zwischen den Figuren 4 und 5 ein Galvanikbad GF oberhalb des Fensters und oberhalb der Lackschicht 14 eingerichtet und der Kernbereich 11k kathodisch geschaltet, während das Galvanikfluid GF anodisch geschaltet ist, so bildet sich nach längerem Galvanikabscheiden eine Keilfläche 20a im Fensterbereich, ausgehend von dem freiliegenden Streifen 11k' der Kathode, unter gesteuertem Wachstum über die elektrisch isolierten Streifen und bei Begrenzung durch die verbleibenden drei vertikalen Flanken des dicken Lacks 14.

Die galvanische Abformung beginnt im Bereich 11k' und von dort aus wächst die Galvanikstruktur 20a in die Aufwachsrichtung -y, wenn man das Koordinatensystem y, x, h(y,x) von **Figur 6 und Figur 3** zugrundelegt. Das Wachsen in Aufwachsrichtung -y erfolgt gesteuert durch Abstand, Breite und Geometrie der isolierten Metallstreifen, die vor Beginn des Galvanikbades festliegen. Das Galvanikmaterial wächst auch senkrecht zur Ebene des Substrates 10 nach oben und wird in drei seitlichen Richtungen vom Lack begrenzt. In der nicht vom Lack 14 begrenzten Richtung entsteht ein dauerndes Wachstum in -y und in h-Richtung durch ein Übergalvanisieren von Insel zu Insel.

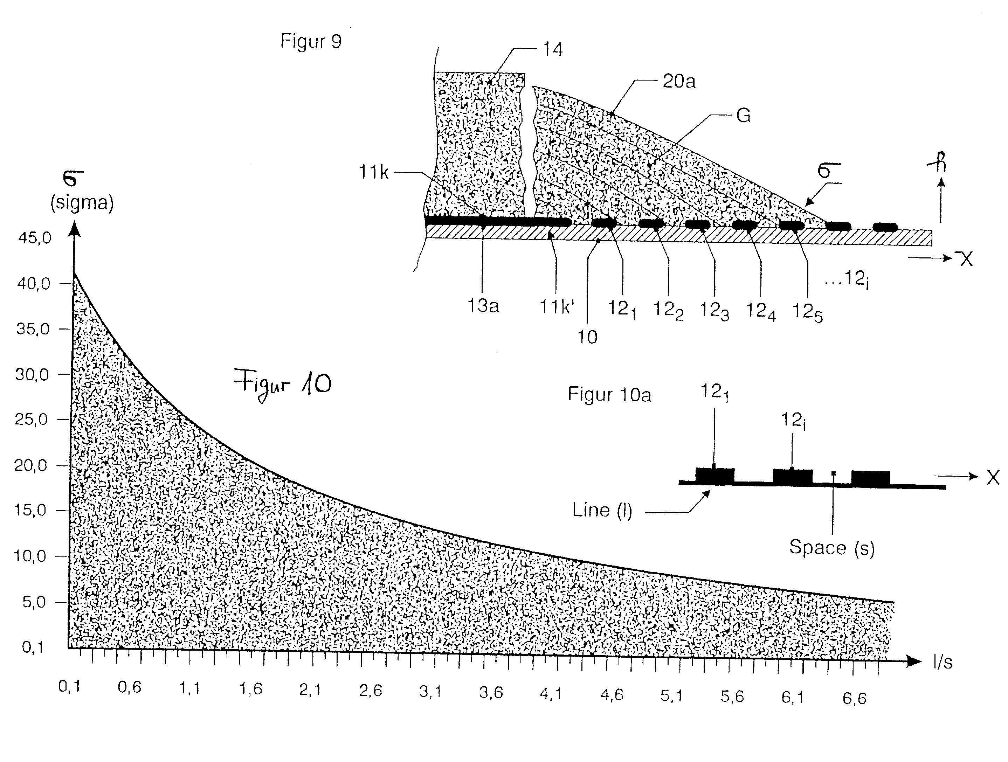

Nachdem die Inselbereiche selbst nicht elektrisch angeschlossen sind, wächst die Galvanikstruktur zunächst in Vertikalrichtung und nur langsam über den isolierten Zwischenbereich herüber, bis sie den nächstliegenden Inselbereich erreicht. Verdeutlicht ist das anhand **der Figur 9**, die neben die **Figur 5** gelegt werden kann, um das stufige Übergalvanisieren über die isolierten Bereiche zwischen den Inseln 12₁, 12₂, 12₃ usw. zu verdeutlichen. Sobald ein Inselbereich von der abgeschiedenen Galvanik-Substanz G erreicht wird, steigt die laterale Aufwachsgeschwindigkeit sprungartig und sinkt für einen Moment die vertikale Aufwachsgeschwindigkeit. Am Ende dieses Inselbereiches dann senkt sich wieder die laterale Aufwachsgeschwindigkeit und steigt dafür die vertikale Aufwachsgeschwindigkeit. Hand in Hand wird so abwechselnd ein Bereich in lateraler Richtung galvanisiert, um dann in vertikaler Richtung erneut zu wachsen. Als Ergebnis ergibt sich eine Schrägstruktur 20a, die mit weiteren Verfahrensschritten **gemäß Figur 6 und 7** noch isoliert auf dem Substrat 10 verbleiben kann, wenn die Lackschicht 14 entfernt wird (Figur 6) und der verbleibende Kernbereich 11k der Plating-Base auch noch entfernt wird (Figur 7).

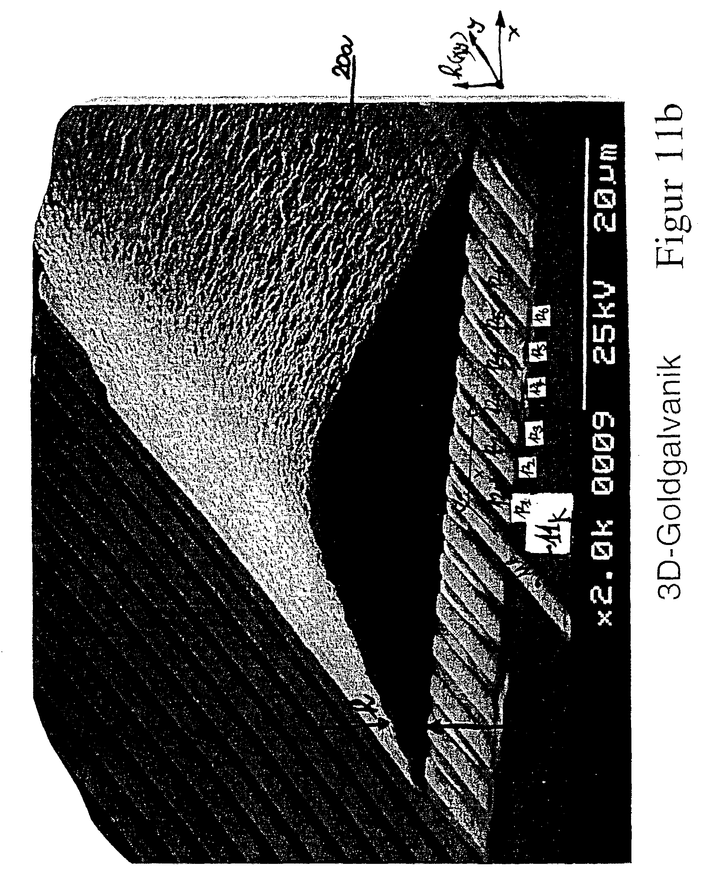

Galvanikstrukturen, die mit dem beschriebenen Verfahren hergestellt worden sind, unter zweiseitiger Begrenzung mit einer Lackstruktur, zeigen die **Figuren 11a und 11b**. In diesen Figuren ist eine hügelförmige Galvanikstruktur 20' bzw. 20a mit zwei Schrägflächen und einem Kamm gebildet, der Zenit liegt über dem Kathodenstreifen 11k, der den Streifen 11k' von Figur 9 und Figur 4 entspricht. Lateral beabstandet sind davon isolierte metallische Streifen 12₁,12₂,12₃ usw., wie auch an Figur 9 erkennbar. Besonders deutlich ist das stufige Übergalvanisieren mit dem vertikalen Nachgalvanisieren in den rechten Randzonen der Figur 11b ersichtlich, wo die Schräge noch deutliche Spuren der sie bildenden Streifenstruktur zeigt. Erst in weiter oben liegenden Bereichen wird die Rinnenstruktur egalisiert und es entsteht eine nahezu flache Schräge.

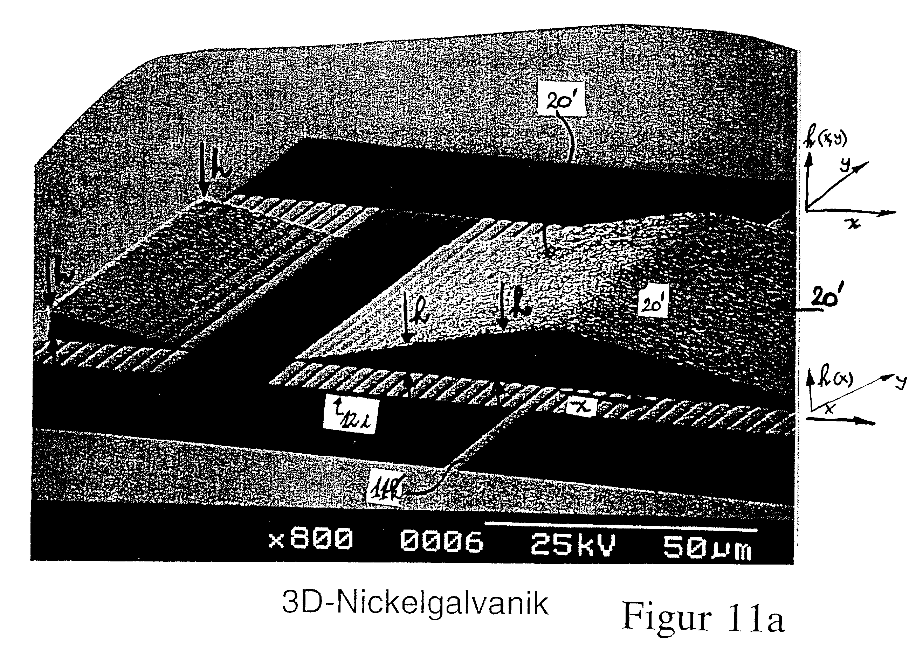

Die Steuerung des Schrägwinkels gemäß Figur 10 erfolgt über die Definition des Abstandes s gemäß Figur 10a und die Breite I der Streifen. Werden andere Strukturen gewählt, die keine Streifen sind, sondern konzentrische oder elliptische Formen, so kann die Funktion der Figur 10 entsprechend verändert sein. Generell orientiert sich der Keilwinkel der gebildeten Schräge daran, daß ein größerer Abstand s und eine kleinere Streifenbreite I beide dazu führen, daß der Keilwinkel größer wird. Sind die Abstände s nicht gleich in x-Richtung, so können auch andere als Schrägstrukturen erzeugt werden, der Winkel der Keilfläche ist dann abhängig vom Abstand zum Kathodengebiet 11k'.

Ein alternatives Herstellungsverfahren ist in den **Figuren 8a bis 8e** beschrieben. Ausgehend von einem Substrat 10 wird eine erste Plating-Layer 23 als leitfähige Startschicht aufgebracht (Figur 8b). Auf diese leitfähige Schicht 23 wird eine Isolierschicht 13b aufgelegt, z.B. durch Bedampfen oder durch Sputtern. In der Isolierschicht wird an geeigneter Stelle ein Kernbereich 23ₖ der ansonsten abgedeckten ersten Leitschicht 23 freigelegt. Das entsprechende Fenster ist mit 13b' bezeichnet, der elektrische Kontakt zum Galvanikfluid kann hier gebildet werden. Die verdeckte Leitschicht 23 dient dabei als Stromzufuhr oder -abfuhr (Figur 8d, Figur 8e).

Auf der Isolierschicht 13b werden Inselbereiche 22ᵢ gebildet, die entweder vor Einbringen des Fensters gemäß Figur 8b oder danach aus einem zweiten Plating-Layer herausstrukturiert werden (durch Belacken und Belichten). Diese Inselbereiche 23ᵢ sind elektrisch von der ersten Leitschicht 23 isoliert (Figur 8e).

Wird das in Figur 8e gezeigte Zwischenprodukt als Ausgangsbasis für ein Galvanisieren gewählt, so bilden sich zunächst am Fenster 13b' oberhalb des Kernbereichs 23ₖ Ablagerungen, die zu den ersten Streifen übergalvanisieren, die dem Fenster 13b' unmittelbar benachbart sind. Ausgehend von dort erfolgt die Bildung der massiven dreidimensionalen Ablagerungsstruktur - z.B. gemäß Figur 9 - so, daß keine randseitigen Beschränkungen von hohen oder dicken Lackschichten zugegen sind. Die Figur 8e bildet also eine Grundlage für in alle Richtungen der Ebene x/y verlaufende Aufwachsraten, gesteuert und beeinflußt von der Struktur der Inselgebiete 22ᵢ oberhalb und isoliert von der innenliegenden Leitschicht 23.

Schematisch sind in der Figur 8e die elektrischen Potentiale (+) und (-) angedeutet, die an das Galvanikfluid GF bzw. die Leitschicht 23 angelegt werden. Die Inselbereiche 22ᵢ sind nicht angeschlossen (n.c.).

In allen Ausführungsbeispielen der vorgeschlagenen Verfahren werden strukturierte Flächen angesprochen. Eine strukturierte Fläche entsteht aus einer ausgedehnten leitfähigen Lage, die aufgesputtert oder aufgedampft worden ist, wobei sich die Metallart der Schicht nach der gewählten (folgenden) Galvanik richtet. Ein Belacken mit einer dünnen, z.B. 1 µm dicken Struktur-Lackschicht folgt und in einem Lithographie-Prozeß kann die Struktur der Leitfähigkeitsschicht durch Belichten und Freilegen (Ätzen oder Ionen-Fräsen) entstehen. Zusätzlich kann sich ein galvanisches Vor-Abformen anschließen, um die Struktur stabiler zu gestalten. Auch kann Metall zusätzlich aufgesputtert werden mit einer geringen Dicke von etwa 100 nm.

## Patentansprüche

1. **Herstellverfahren** für ein in Höhenrichtung [h(x,y)] gestaltetes galvanisch abgeschiedenes Metallprofil (G;20a,20b;20') auf einem Substrat (10), wobei
(a) eine zuvor aufgebrachte leitfähige Schicht (11,21,23) in Lateralrichtung (x,y) in einen ersten (11k,-) und mehrere zweite Bereiche (12ᵢ) strukturiert wird;
(b) der erste Bereich (11k,-) der strukturierten leitfähigen Schicht (11,23) auf ein kathodisches Potential gebracht wird, um dort mit der galvanischen Abscheidung (G) zu beginnen;
(c) ein Übergalvanisieren über isolierte Strecken (10,13) hin zu den individuell leitfähigen aber elektrisch nicht angeschlossenen zweiten Bereichen der Lateralstruktur erfolgt, um das leitende Metallprofil (G;20a,20b;20') zu bilden.

2. Verfahren nach Anspruch 1, bei dem die Strukturierung aus der Gestaltung eines Kernbereiches (11ₖ,23ₖ; k=1...n) und davon beabstandeten Inselbereichen (12ᵢ; 22ᵢ; i=1...m) besteht, welch letztere vom Kernbereich und weitgehend untereinander isoliert sind.

3. Verfahren nach einem der erwähnten Ansprüche, wobei beim Galvanisieren (Beschichten mit elektrisch leitfähigen Substanzen) die Kern- bzw. Inselbereiche (11ₖ,23ₖ,12ᵢ,22ᵢ) unterschiedliche Potentiale haben, insbesondere kathodisches Potential bzw. demgegenüber im wesentlichen isoliert sind.

4. Verfahren nach einem der erwähnten Ansprüche, bei dem die laterale Strukturierung erfolgt, indem die aufgebrachte leitfähige Schicht (11,23) dünn mit lichtempfindlichem Lack beschichtet wird und in einem Lithographieverfahren lateral (x,y) strukturiert wird.

5. Verfahren nach Anspruch 4, bei dem die mit dünnem Lack strukturierte Fläche
(a) galvanisch abgeformt wird; oder
(b) durch Aufbringen (Sputtern, Dampfen) von Metall strukturiert beschichtet wird;
um voneinander beabstandete Leitbereiche (11ₖ,12ᵢ;23ₖ,22ᵢ) zu schaffen.

6. Verfahren nach einem der erwähnten Ansprüche, bei dem auf der (strukturierten) leitfähigen Schicht (11) eine dicke Schicht aus Lack (14) aufgebracht wird, in den Inselbereichen (12i) freibelichtet und freigelegt sowie von dem Kernbereich (11ₖ,23ₖ) zumindest ein Teilbereich (11ₖ',23ₖ) freigelegt werden.

7. Verfahren nach einem der erwähnten Ansprüche, bei dem der Kernbereich (23ₖ) tiefer liegt als die Inselbereiche (22ᵢ) und die beiden Bereiche von einer Isolationsschicht (13) getrennt sind.

8. Verfahren nach einem der erwähnten Ansprüche, bei dem der nicht lateral strukturierte Teil (11ₖ,23ₖ) der aufgebrachten Schicht (Plating-Base; 11,23) nach Ausformen der in Höhenrichtung gestaltbaren (h(x,y)) galvanisch abgeschiedenen Struktur vom Substrat (10) entfernt wird, zuvor ggf. der darauf aufgebrachte (dicke) Lackbereich (14) entfernt wird.

9. Verfahren nach einem der erwähnten Ansprüche, bei dem die Höhe der galvanisch abgeformten Struktur im Größenbereich von 1µm bis 100µm liegt, insbesondere unterhalb 10µm.

10. Verfahren nach einem der erwähnten Ansprüche, bei dem das Metallprofil eine Schrägstruktur ist.

11. Verfahren nach einem der erwähnten Ansprüche, bei dem zwischen Substrat (10) und erster Plating-Base (11) eine Isolierschicht (13a), insbesondere aus SiN, aufgebracht wird.

12. Verfahren nach einem der erwähnten Ansprüche, bei dem durch Variation des Abstandes (s), der Breite (I) und/oder der Geometrie der Inselbereiche gegenüber dem Kernbereich die Form der durch Galvanikabscheidung gebildeten Struktur veränderbar ist bzw. verändert wird (Fig. 10).

13. Verfahren nach einem der erwähnten Ansprüche, bei dem die dicke Lackschicht (14) wesentlich dicker als 1µm ist und die dünne Lackschicht im Größenordnungsbereich von 1µm liegt.

14. Verfahren nach einem der Ansprüche 7 bis 13, bei dem der tiefer liegende Kernbereich (23) ein freigelegter (13b') Bereich einer zweiten leitfähigen Schicht (Plating-Base;23) ist, die vor der ersten leitfähigen Schicht auf das Substrat (10) aufgebracht worden ist.

15. Verfahren nach Anspruch 14, bei dem die zweite Leitschicht (23) gegenüber der ersten Leitschicht - auch nach deren Strukturierung - isoliert ist (13b).

16. **Herstellverfahren** für dreidimensional (x,y,h) geformte Metallprofile (20,20a,20b,20') für die Mikromechanik (40), bei dem
(a) auf das Substrat (10) zumindest eine leitfähige Schicht (11,23) aufgebracht wird;
(b) die zumindest eine leitfähige Schicht (11,23) lateral (x,y) strukturiert wird, indem eine Mehrzahl lateral beabstandeter, isolierter Inselbereiche (12ᵢ,22ᵢ; i=1...n) gebildet werden;
**dadurch gekennzeichnet,** daß
(c) einer der Inselbereiche als Kernbereich (11 k,23k) beim Galvanisieren kathodisch (-) geschaltet wird und die anderen Inselbereiche elektrisch nicht angeschlossen werden (n.c.), um zumindest eine der Flanken des geformten Metallprofils schräg oder gekrümmt auszubilden.

17. Herstellverfahren nach Anspruch 16, bei dem zwei leitfähige Schichten übereinander aber zueinander schlecht oder nicht elektrisch leitend auf das Substrat (10) aufgebracht werden, wobei während des Galvanisierens die zuerst aufgebrachte Leitschicht (23) zumindest in einem Kernbereich (23ₖ) eine frei mit einem Galvanikfluid (GF) in Kontakt stehende Kathode bildet.

18. Herstellverfahren nach einem der erwähnten Ansprüche, bei dem die dreidimensional formbare Metallstruktur im wesentlichen kontinuierlich, wie sinus- oder cosinusförmig oder nach Art einer e-Funktion oder einer 1-e-Funktion ihre Dicke (h(x)) ändert, insbesondere in zwei zueinander senkrechten Richtungen (x,y).

19. Herstellverfahren nach Anspruch 16, bei dem vor dem Galvanisieren der Bereich (11ₖ) der Plating-Base (11), der nicht lateral strukturiert ist, mit Lack (14) beschichtet wird, insbesondere dadurch, daß der Gesamtbereich mit Lack beschichtet wird und der strukturierte Teil (11ᵢ) der Plating-Base (11) entlackt wird.

20. Herstellverfahren nach Anspruch 16 oder 19, bei dem die dreidimensional formbare Metallstruktur (20,20a) zumindest eine Schräge (20a,20') aufweist, die sich rampenähnlich vom Substrat (10) zu einem höherliegenden Bereich einer dicken Lackschicht (14), die auf der nicht strukturierten (11ₖ) Plating-Base (11) aufgebracht ist, erstreckt.

21. Herstellverfahren nach einem der erwähnten Ansprüche, bei dem die Metallstruktur durch ein Galvanikverfahren auf das Substrat (10) abgeschieden wird, unter lateraler Steuerung der Aufwachsrate anhand von Abstand und Größe (s,l) der nicht oder schlecht elektrisch angeschlossenen Inselbereiche (12ᵢ,22ᵢ).

22. Herstellverfahren nach einem der erwähnten Ansprüche, bei dem die in Höhenrichtung gestaltbare Leitstruktur (20,20a,20b,20') massiv ist, unter spürbarer bis deutlicher Reduzierung ihrer lateralen Abmessung in Schichten, die - ausgehend vom Substrat - in h-Richtung beabstandet sind.

23. **3D-Massivstruktur,** erhalten mit einem Verfahren nach einem der vorigen Ansprüche, bestehend vollumfänglich aus metallischer Substanz (G) mit zumindest einer schrägen oder in Höhenrichtung (h) gekrümmten Fläche (20',20a,20b) auf einem Substrat (10), wobei sich auf dem Substrat (10) im Boden der dreidimensionalen Massivstruktur im lateralen Bereich der schrägen oder in Höhenrichtung gekrümmten Fläche beabstandete leitende Inselbereiche (12i) befinden.

## Claims

1. Production process for an electrodeposited metal profile (G; 20a, 20b; 20') constructed in height direction [h(x,y)] on a substrate (10), wherein
(a) a previously applied conductive layer (11, 21, 23) is structured in the lateral direction (x, y) in a first (11k,-) and several second regions (12ᵢ);
(b) the first region (11k,-) of the structured conductive layer (11, 23) is brought to a cathodic potential to start electrodeposition (G) there;
(c) electrodeposition over insulated paths (10, 13) towards the individually conductive but electrically non-connected second regions of the lateral structure takes place to form the conductive metal profile (G; 20a, 20b; 20').

2. Process according to claim 1, in which structuring comprises constructing a core region (11ₖ, 23ₖ; k=1...n) and island regions (12ᵢ; 22ᵢ; i=1...m) at a distance therefrom, which latter are insulated from the core region and largely from one another.

3. Process according to one of the claims mentioned, wherein during electrodeposition (coating with electrically conductive substances) the core or island regions (11ₖ, 23ₖ, 12ᵢ, 22ᵢ) have different potentials, in particular cathodic potential or in contrast are essentially insulated.

4. Process according to one of the claims mentioned, in which lateral structuring takes place by coating the applied conductive layer (11, 23) thinly with light-sensitive lacquer and structuring laterally (x, y) in a lithography process.

5. Process according to claim 4, in which the surface structured with thin lacquer
(a) is formed by electrodeposition; or
(b) is coated to be structured by applying (sputtering, vaporising) metal; to provide conductive regions (11ₖ, 12ᵢ; 23ₖ, 22ᵢ) at a distance from one another.

6. Process according to one of the claims mentioned, in which a thick layer of lacquer (14) is applied to the (structured) conductive layer (11), freely illuminated and exposed in the island regions (12i) and at least a part region (11ₖ', 23ₖ') is exposed by the core region (11ₖ, 23ₖ).

7. Process according to one of the claims mentioned, in which the core region (23ₖ) is lower than the island regions (22 ᵢ) and the two regions are separated by an insulation layer (13).

8. Process according to one of the claims mentioned, in which the non-laterally structured part (11ₖ, 23ₖ) of the applied layer (plating base; 11, 23) is removed from the substrate (10) after forming the electrodeposited structure which can be constructed (h(x,y)) in the height direction, before optionally the (thick) lacquer region (14) applied thereto is removed.

9. Process according to one of the claims mentioned, in which the height of the structure formed by electrodeposition is in the size range from 1 µm to 100 µm, in particular below 10 µm.

10. Process according to one of the claims mentioned, in which the metal profile is a bevelled structure.

11. Process according to one of the claims mentioned, in which an insulating layer (13a), in particular of SiN, is applied between substrate (10) and first plating base (11).

12. Process according to one of the claims mentioned, in which the shape of the structure formed by electrodeposition can be altered or is altered (Figure 10) by varying the distance (s), the width (l) and/or the geometry of the island regions with respect to the core region.

13. Process according to one of the claims mentioned, in which the thick lacquer layer (14) is considerably thicker than 1 µm and the thin lacquer layer is in the order of magnitude range of 1 µm.

14. Process according to one of claims 7 to 13, in which the lower lying core region (23) is an exposed (13b') region of a second conductive layer (plating base; 23), which has been applied to the substrate (10) before the first conductive layer.

15. Process according to claim 14, in which the second conductive layer (23) is insulated (13b) with respect to the first conductive layer - even after it has been structured.

16. Production process for three-dimensionally (x,y,h) shaped metal profiles (20, 20a, 20b, 20') for micromechanics (40), in which
(a) at least one conductive layer (11, 23) is applied to the substrate (10);
(b) the at least one conductive layer (11, 23) is structured laterally (x,y) by forming a plurality of laterally spaced, insulated island regions (12ᵢ; 22_{I}; i=1...n); characterised in that
(c) one of the island regions is cathodically (-) connected during electrodeposition as core region (11k, 23k) and the other island regions are not connected electrically (n.c.) in order to shape at least one of the flanks of the shaped metal profile to be bevelled or curved.

17. Production process according to claim 16, in which two conductive layers are applied to the substrate (10) one above another, but so as to have poor electrical conduction with one another or not to be electrically conductive, wherein during electrodeposition the initially applied conductive layer (23) forms a cathode in free contact with an electrodeposition fluid (GF) at least in a core region (23ₖ).

18. Production process according to one of the claims mentioned, in which the three-dimensionally shapable metal structure changes its thickness (h(x)) essentially continuously, such as sinusoidally or like a cosine or like an e function or a 1-e function, in particular in two directions (x,y) which are vertical to one another.

19. Production process according to claim 16, in which before electrodeposition, the region (11ₖ) of the plating base (11), which is not laterally structured, is coated with lacquer (14), in particular in that the entire region is coated with lacquer, and lacquer is removed from the structured part (11ᵢ) of the plating base (11).

20. Production process according to claim 16 or 19, in which the three-dimensionally shapable metal structure (20, 20a) has at least one bevel (20a, 20') which extends like a ramp from the substrate (10) to a higher region of a thick lacquer layer (14) which is applied to the non-structured (11ₖ) plating base (11).

21. Production process according to one of the claims mentioned, in which the metal structure is deposited on the substrate (10) by means of an electrodeposition process, with lateral control of the growth rate using distance and size (s,l) of the non-electrically connected or poorly electrically connected island regions (12ᵢ, 22ᵢ).

22. Production process according to one of the claims mentioned, in which the conductive structure (20, 20a, 20b, 20') which can be constructed in the height direction is solid, with perceptible to significant reduction of its lateral dimension in layers, which - starting from the substrate - are spaced in the h direction.

23. 3D solid structure obtained by a process according to one of the previous claims, consisting extensively of metallic substance (G) having at least one surface (20', 20a, 20b) bevelled or curved in height direction (h) on a substrate (10), wherein spaced conductive island regions (12i) are situated on the substrate (10) in the base of the three-dimensional solid structure in the lateral region of the surface bevelled or curved in height direction.

## Revendications

1. Procédé de production d'un profil métallique (G;20a,20b;20') séparé galvaniquement configuré dans le sens de la hauteur [h(x,y)] sur un substrat (10), dans lequel :
(a) une couche conductrice (11,21,23) appliquée préalablement est structurée dans la direction latérale (x,y) en une première zone (11k.-) et en plusieurs secondes zones (12ⱼ);
(b) la première zone (11k,-) de la couche conductrice structurée (11,23) est soumise à un potentiel cathodique pour commencer à cet endroit la séparation galvanique (G);
(c) il se produit une surgalvanisation sur des sections isolées (10,13) dans les secondes zones individuellement conductrices, mais électriquement non connectées, de la structure latérale pour former le profil métallique conducteur (G;20a,20b;20').

2. Procédé selon la revendication 1, dans lequel la structuration est constituée par la formation d'une zone centrale (11ₖ,23ₖ; k=1...n) et de zones formant îlots (12ⱼ;22ⱼ; j=1...m) qui en sont espacées, ces dernières zones étant isolées de la zone centrale et largement isolées les uns des autres.

3. Procédé selon l'une quelconque des revendications précédentes, dans lequel, lors de la galvanisation (revêtement par des substances conductrices de l'électricité), la zone centrale ou les zones formant îlots (11ₖ,23ₖ,12ⱼ,22ⱼ) ont des potentiels différents, en particulier, un potentiel cathodique ou sont sensiblement isolées par rapport à celui-ci.

4. Procédé selon l'une quelconque des revendications précédentes, dans lequel la structuration latérale se fait en revêtant la couche conductrice appliquée (11,23) d'une couche mince de vernis photosensible et la structurant latéralement (x, y) par un procédé lithographique.

5. Procédé selon la revendication 4, dans lequel la surface structurée par la couche mince de vernis
(a) est formée galvaniquement; ou
(b) est revêtue de manière structurée par application (pulvérisation, vaporisation) d'un métal; pour former des zones conductrices (11ₖ,12ⱼ; 23ₖ,22ⱼ) espacées les unes des autres.

6. Procédé selon l'une quelconque des revendications précédentes, dans lequel on applique sur la couche conductrice (structurée) (11) une couche épaisse de vernis (14), des zones formant îlots (12ᵢ) étant exposées librement et dégagées et au moins une zone partielle (11ₖ',23ₖ) étant dégagée également de la zone centrale (11ₖ,23ₖ).

7. Procédé selon l'une quelconque des revendications précédentes, dans lequel la zone centrale (23ₖ) est plus profonde que les zones formant îlots (22ⱼ) et les deux types de zones sont séparés par une couche isolante (13).

8. Procédé selon l'une quelconque des revendications précédentes, dans lequel la partie (11ₖ,23ₖ) non structurée latéralement de la couche appliquée (base de métallisation; 11,23) est éliminée du substrat (10) après formation de la structure séparée galvaniquement configurable dans le sens de la hauteur (h(x,y)), éventuellement avant que la zone de vernis (14) (épaisse) appliquée sur le substrat ne soit éliminée.

9. Procédé selon l'une quelconque des revendications précédentes, dans lequel la hauteur de la structure formée galvaniquement se situe dans une plage de 1 µm à 100 µm, en particulier en dessous de 10 µm.

10. Procédé selon l'une quelconque des revendications précédentes, dans lequel le profil métallique est une structure inclinée.

11. Procédé selon l'une quelconque des revendications précédentes, dans lequel une couche isolante (13a), en particulier constituée de SiN, est appliquée entre le substrat (10) et la première base de métallisation (11).

12. Procédé selon l'une quelconque des revendications précédentes, dans lequel, par variation de la distance (s), de la largeur (1) et/ou de la géométrie des zones formant îlots par rapport à la zone centrale, la forme de la structure formée par séparation galvanique peut être modifiée ou est modifiée (Fig. 10).

13. Procédé selon l'une quelconque des revendications précédentes, dans lequel la couche de vernis épaisse (14) est sensiblement plus épaisse que 1 µm et la couche de vernis mince a une épaisseur d'un ordre de grandeur de 1 µm.

14. Procédé selon l'une quelconque des revendications 7 à 13, dans lequel la zone centrale plus profonde (23) est une zone dégagée (13b') d'une seconde couche conductrice (base de métallisation; 23) qui a été appliquée sur le substrat (10) avant la première couche conductrice.

15. Procédé selon la revendication 14, dans lequel la seconde couche conductrice (23) est isolée (13b) de la première couche conductrice - même après sa structuration.

16. Procédé de production de profils métalliques (20,20a,20b,20') de forme tridimensionnelle (x,y,h) pour micromécanique (40), dans lequel :
(a) au moins une couche conductrice (11,23) est appliquée sur le substrat (10);
(b) la au moins une couche conductrice (11,23) est structurée latéralement (x,y) en formant une pluralité de zones formant îlots (12j,22j; j=1...n) isolées et espacées latéralement;
caractérisé en ce que :
(c) une des zones formant îlots est commutée à un potentiel cathodique (-) comme zone centrale (11k,23k) lors de la galvanisation et les autres zones formant îlots ne sont pas connectées électriquement pour donner au moins à un des flancs du profil métallique formé une conformation inclinée ou courbe.

17. Procédé de production selon la revendication 16, dans lequel deux couches conductrices sont appliquées sur le substrat (10) en superposition, mais avec une conduction mutuelle faible ou nulle de l'électricité, la couche conductrice (23) appliquée en premier lieu formant, au cours de la galvanisation, au moins dans une zone centrale (23k), une cathode venant librement en contact avec un fluide galvanique (GF).

18. Procédé de production selon l'une quelconque des revendications précédentes, dans lequel la structure métallique configurable en trois dimensions modifie son épaisseur (h(x)) sensiblement en continu, notamment selon une fonction sinusoïdale ou cosinusoïdale ou selon un type de fonction e ou 1-e, en particulier dans deux directions (x,y) mutuellement perpendiculaires.

19. Procédé de production selon la revendication 16, dans lequel, avant la galvanisation, la zone (11k) de la base de métallisation (11), qui n'est pas structurée latéralement, est revêtue d'un vernis (14), en particulier caractérisé en ce que toute la zone est revêtue de vernis et le vernis de la partie structurée (11j) de la base de métallisation est éliminé.

20. Procédé de production selon la revendication 16 ou 19, dans lequel la structure métallique (20,20a) configurable en trois dimensions présente au moins une partie inclinée (20a,20') qui s'étend en rampe du substrat (10) à une zone en hauteur d'une couche de vernis épaisse (14), qui est appliquée sur la base de métallisation (11) non structurée (11ₖ).

21. Procédé de production selon l'une quelconque des revendications précédentes, dans lequel la structure métallique est séparée sur le substrat (10) par un procédé galvanique en commandant latéralement le taux de croissance sur la base de la distance et de la grandeur (s,l) des zones formant îlots (12j,22j) peu ou pas connectées électriquement.

22. Procédé de production selon l'une quelconque des revendications précédentes, dans lequel la structure conductrice (20,20a,20b,20') configurable en hauteur est massive en réduisant de manière à peine visible à nette sa dimension latérale dans des couches qui sont espacées dans la direction h - à partir du substrat.

23. Structure massive tridimensionnelle obtenue par un procédé selon l'une quelconque des revendications précédentes, constituée sur toutes la périphérie d'une substance métallique (G) avec au moins une surface (20',20a,20b) inclinée ou courbe dans le sens (h) de la hauteur sur un substrat (10), des zones conductrices formant îlots (12j) espacées dans la zone latérale de la surface inclinée ou courbe dans le sens de la hauteur, se trouvant sur le substrat (10) dans le fond de la structure massive tridimensionnelle.
